# EUROPEAN PATENT APPLICATION

(11) **EP 4 800 737 A1**
(43) Date of publication of application: **02.09.2026**
(21) Application number: 26160338.5
(22) Date of filing: 24.02.2026
(51) Int. Cl.: H01J 37/22, H01J 37/252

(54) **ANALYZER AND ANALYSIS METHOD**

(30) Priority: 26.02.2025 JP 2025029073
(71) Applicant: Jeol Ltd., Akishima, Tokyo 196-8558 (JP)
(72) Inventor: KATO, Koki, Tokyo, 196-8558 (JP); NAKAMURA, Naoki, Tokyo, 196-8558 (JP)
(74) Representative: Boult Wade Tennant LLP

(57) **Abstract**

An analyzer (100) includes: a specimen stage (20) that supports a specimen (S) and is capable of changing a position of the specimen (S); an electron optical system (10) that irradiates the specimen (S) with an electron beam (EB); a spectrometer (50) that separates and detects an X-ray with a specific wavelength from X-rays emitted from the specimen (S); an imaging device (60) that captures an optical image of the specimen (S); and a control unit (70) that adjusts a position of the specimen (S) so as to satisfy a focusing condition of the spectrometer (50). The imaging device (60) includes a variable focal length lens (66) that electrically changes a focal length, and the control unit (70) causes the specimen stage (20) to move the specimen (S) to a position satisfying the focusing condition based on a value of an electric signal supplied to the variable focal length lens (66) when a focus of the imaging device (60) has been adjusted to the specimen (S).

## Description

### BACKGROUND OF THE INVENTION

### Field of the Invention

The present invention relates to an analyzer and an analysis method.

### Description of Related Art

Spectrometers such as a wavelength-dispersive X-ray spectrometer (WDS) and a soft X-ray emission spectrometer (SXES) separate and detect X-rays with a specific wavelength from characteristic X-rays emitted from a specimen. The WDS analyzes the wavelength using an analyzing crystal, and the SXES analyzes the wavelength using a diffraction grating.

In the WDS and SXES, the positional relationship among a specimen, a spectroscopic element, and a detector is required to satisfy the focusing condition. When the focusing condition is not satisfied, the X-ray intensity may decrease and the spectrum may shift. Therefore, in the case of analysis using WDS or SXES, a specimen needs to be placed at a position satisfying the focusing condition.

For example, JP 2022-116542 A discloses an electron probe microanalyzer (EPMA) having the function of measuring the height of a specimen using a laser. In the EPMA disclosed in JP 2022-116542 A, the height of a specimen is measured using the height measurement function using a laser, and the height of the specimen is manually adjusted so as to satisfy the focusing condition.

In analyzing devices including the WDS or SXES, in order to efficiently perform analysis, it is desirable to place a specimen in a short time at a position satisfying the focusing condition.

### SUMMARY OF THE INVENTION

According to a first aspect of the present disclosure, there is provided an analyzer including:
a specimen stage that supports a specimen and is capable of changing a position of the specimen;
an electron optical system that irradiates the specimen with an electron beam;
a spectrometer that separates and detects an X-ray with a specific wavelength from X-rays emitted from the specimen;
an imaging device that captures an optical image of the specimen; and
a control unit that adjusts a position of the specimen so as to satisfy a focusing condition of the spectrometer,
wherein
the imaging device includes a variable focal length lens that electrically changes a focal length, and
the control unit causes the specimen stage to move the specimen to a position satisfying the focusing condition based on a value of an electric signal supplied to the variable focal length lens when a focus of the imaging device has been adjusted to the specimen.

According to a second aspect of the present disclosure, there is provided an analysis method using an analyzer including an electron optical system that irradiates a specimen with an electron beam, a spectrometer that separates and detects an X-ray with a specific wavelength from X-rays emitted from the specimen, and an imaging device that captures an optical image of the specimen and has a variable focal length lens that electrically changes a focal length, the analysis method including:
using the variable focal length lens to adjust a focus of the imaging device to the specimen;
acquiring a value of an electric signal supplied to the variable focal length lens when the focus of the imaging device has been adjusted to the specimen; and
moving, based on a value of the electric signal, the specimen to a position satisfying a focusing condition.

### BRIEF DESCRIPTION OF THE DRAWINGS

FIG. 1 illustrates an example of a configuration of an analyzer according to an embodiment of the present invention.
FIG. 2 is a diagram for describing a method for acquiring a spectrum in a WDS.
FIG. 3 is a flowchart illustrating an example of analysis processing of a control unit.
FIG. 4 is a diagram for describing processing for placing a specimen at a reference height.
FIG. 5 is a flowchart illustrating an example of processing by a control unit for acquiring information on a relationship between a lens voltage V and a distance D.
FIG. 6 is a graph illustrating a relationship between a lens voltage V and a distance D.
FIG. 7 is a flowchart illustrating an example of observation processing of a control unit.
FIG. 8 is a flowchart illustrating an example of processing by a control unit for creating a lens voltage map.
FIG. 9 illustrates an example of a configuration of an analyzer according to the first modification example.

### DESCRIPTION OF THE INVENTION

According to an embodiment of the present disclosure, there is provided an analyzer including:
a specimen stage that supports a specimen and is capable of changing a position of the specimen;
an electron optical system that irradiates the specimen with an electron beam;
a spectrometer that separates and detects an X-ray with a specific wavelength from X-rays emitted from the specimen;
an imaging device that captures an optical image of the specimen; and
a control unit that adjusts a position of the specimen so as to satisfy a focusing condition of the spectrometer,
wherein
the imaging device includes a variable focal length lens that electrically changes a focal length, and
the control unit causes the specimen stage to move the specimen to a position satisfying the focusing condition based on a value of an electric signal supplied to the variable focal length lens when a focus of the imaging device has been adjusted to the specimen.

In such an analyzer, a specimen is moved to a position satisfying the focusing condition on a specimen stage on the basis of the value of an electric signal supplied to a variable focal length lens when the focus of an imaging device is adjusted to the specimen, so that the specimen can be placed in a short time at the position satisfying the focusing condition.

According to an embodiment of the present disclosure, there is provided an analysis method using an analyzer including an electron optical system that irradiates a specimen with an electron beam, a spectrometer that separates and detects an X-ray with a specific wavelength from X-rays emitted from the specimen, and an imaging device that captures an optical image of the specimen and has a variable focal length lens that electrically changes a focal length, the analysis method including:
using the variable focal length lens to adjust a focus of the imaging device to the specimen;
acquiring a value of an electric signal supplied to the variable focal length lens when the focus of the imaging device has been adjusted to the specimen; and
moving, based on a value of the electric signal, the specimen to a position satisfying a focusing condition.

In such an analysis method, the specimen is moved to a position satisfying the focusing condition on the basis of the value of an electric signal supplied to the variable focal length lens when the focus of the imaging device is adjusted to the specimen, so that the specimen can be placed in a short time at the position satisfying the focusing condition.

Preferred embodiments of the invention will be described in detail below with reference to the drawings. It is noted that the following embodiments do not unduly limit the contents of the invention described in the claims. In addition, all of the components described below are not necessarily essential requirements of the invention.

### 1. Analyzer

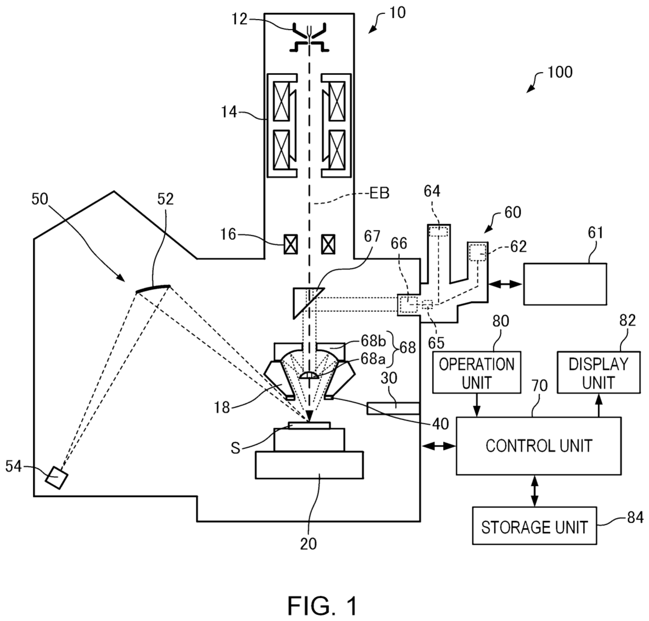

First, an analyzer according to an embodiment of the present invention will be described with reference to the accompanying drawings. FIG. 1 illustrates an example of the configuration of an analyzer 100 according to an embodiment of the present invention. The analyzer 100 is a scanning electron microscope equipped with a plurality of wavelength-dispersive X-ray spectrometers (WDS). Alternatively, the analyzer 100 may be an electron probe micro analyzer (EPMA) equipped with the WDS.

As illustrated in FIG. 1, the analyzer 100 includes an electron optical system 10, a specimen stage 20, a secondary electron detector 30, a backscattered electron detector 40, a WDS 50, an imaging device 60, a control unit 70, an operation unit 80, a display unit 82, and a storage unit 84.

The electron optical system 10 emits an electron beam EB to a specimen S. The electron optical system 10 includes an electron gun 12, a condenser lens 14, a deflector 16, and an objective lens 18.

The electron gun 12 emits the electron beam EB. The electron gun 12 emits the electron beam EB, which is accelerated by a predetermined acceleration voltage, to the specimen S.

The condenser lens 14 focuses the electron beam EB emitted from the electron gun 12. The deflector 16 two-dimensionally deflects the electron beam EB. The deflector 16 allows scanning on the specimen S with the electron beam EB. The objective lens 18 focuses the electron beam EB on the specimen S. An electron probe can be formed by focusing the electron beam EB through the condenser lens 14 and the objective lens 18.

The specimen stage 20 supports the specimen S. The specimen S is placed on the specimen stage 20. Although not shown, the specimen stage 20 has a moving mechanism for moving the specimen S. For example, the specimen S can be scanned with the electron beam EB by moving the specimen S on the specimen stage 20.

The secondary electron detector 30 is a detector that detects secondary electrons emitted from the specimen S. The specimen S is scanned with the electron beam EB, and secondary electrons emitted from the specimen S are detected by the secondary electron detector 30, thereby obtaining a secondary electron image. The backscattered electron detector 40 is a detector that detects backscattered electrons emitted from the specimen S. The specimen S is scanned with the electron beam EB, and backscattered electrons emitted from the specimen S are detected by the backscattered electron detector 40, thereby obtaining a backscattered electron image.

The WDS 50 separates and detects X-rays with a specific wavelength from characteristic X-rays emitted from the specimen S. The WDS 50 includes spectroscopic elements 52 and an X-ray detector 54. In the WDS 50, characteristic X-rays generated from the specimen S are analyzed by the spectroscopic elements 52, and the analyzed X-rays are detected by the X-ray detector 54.

The spectroscopic element 52 is, for example, an analyzing crystal for performing analysis using an X-ray diffraction phenomenon. The WDS 50 includes the spectroscopic elements 52 having different crystal plane intervals. That is, the spectroscopic elements 52 have different spectral wavelength ranges. Examples of the spectroscopic element 52 include pentaerythritol (PET), lithium fluoride (LIF), thallium acid phthalate (TAP), and stearate (STE). The X-ray detector 54 detects the characteristic X-rays analyzed by the spectroscopic elements 52.

The WDS 50 has a drive unit for moving the spectroscopic elements 52 and the X-ray detector 54. The drive unit moves the spectroscopic elements 52 and the X-ray detector 54 by, for example, motor driving. Thus, the spectroscopic elements 52 and the X-ray detector 54 can be arranged at desired positions. In the WDS 50, X-rays can be detected with a wavelength (energy) corresponding to the position of the spectroscopic element 52.

The imaging device 60 captures an optical image of the specimen S. The optical image is used to adjust the specimen S on the specimen stage 20 to a reference height (reference position), which is a position satisfying the focusing condition of the WDS 50. The optical image is an image of the specimen surface captured using visible light.

The imaging device 60 includes an imaging element 62, a light source 64, a focusing lens 65, a liquid lens 66, a mirror 67, and an objective lens 68.

The imaging element 62 is, for example, a charge coupled device (CCD) image sensor or a complementary metal oxide semiconductor (CMOS) image sensor. Data of the optical image captured by the imaging device 60 is output from the imaging element 62. The data of the optical image is sent to the control unit 70. The light source 64 is a light source for illuminating the specimen S. The light source 64 is, for example, a luminaire such as a light emitting diode (LED).

The focusing lens 65 is a lens for adjusting the focus of the imaging device 60. The focusing lens 65 is disposed between the imaging element 62 and the liquid lens 66. The liquid lens 66 is a variable focal length lens that electrically changes the focal length. In the liquid lens 66, for example, the focal length is changed by applying a voltage to change the shape of liquid constituting the lens. Therefore, in comparison with mechanical focusing or focusing while moving the specimen S, the focus of the imaging device 60 can be adjusted in a shorter time. The liquid lens 66 changes the focal length according to, for example, the value of voltage applied to the liquid lens 66. The liquid lens 66 has, for example, an actuator including a piezoelectric element. The shape of the liquid constituting the lens may be changed by applying a voltage to the actuator.

In this case, the liquid lens 66 that changes the focal length according to the value of applied voltage is used as a variable focal length lens used for the imaging device 60. The variable focal length lens used for the imaging device 60 is not particularly limited if the lens changes the focal length according to the value of an electric signal supplied to the lens. For example, the variable focal length lens may be a lens that changes the focal length according to the value of current applied to the lens.

The objective lens 68 is a reflection objective lens including a concave lens 68a and a convex lens 68b. The mirror 67 is disposed on an optical path between the liquid lens 66 and the objective lens 68. The mirror 67 is placed on the optical axis of the electron beam EB and has a through hole through which the electron beam EB passes.

In the imaging device 60, the imaging element 62, the focusing lens 65, the liquid lens 66, the mirror 67, and the and the objective lens 68 are arranged on the optical path in this order. The objective lens 68 is disposed immediately above the specimen S.

The imaging device 60 has an autofocus function that is the function of automatically adjusting the focus. The imaging device 60 includes an imaging control unit 61 for performing the autofocus function. The imaging control unit 61 can be implemented by executing a program stored in the storage unit by hardware such as various processors (including a central processing unit (CPU) and a digital signal processor (DSP)). The imaging control unit 61 may be implemented by, for example, a general-purpose circuit such as a microcontroller or a microprocessor that operates according to a program, or by a dedicated circuit such as an application specific integrated circuit (ASIC).

The imaging control unit 61 sets the lens voltage to any lens voltage value, captures an image of the specimen S to obtain an optical image, and calculates a focus value from the captured optical image. The focus value is an index that indicates the degree of focus of an image in the optical image, and is proportional to, for example, the contrast of the image. In an optical image, the higher the degree of focus, the higher the contrast (the larger the difference in brightness), so that the focus value increases.

The imaging control unit 61 then changes the lens voltage value, captures an image of the specimen S to obtain an optical image, and calculates the focus value. As described above, the imaging control unit 61 repeats the process of changing the lens voltage value, acquiring an optical image, and calculating the focus value of the optical image to search for a lens voltage value with the maximum focus value. The imaging control unit 61 sets the voltage value with the maximum focus value as a lens voltage to be applied to the liquid lens 66. Thus, the lens voltage with the maximum focus value is applied to the liquid lens 66, and the focus of the imaging device 60 can be adjusted to the specimen S.

The imaging device 60 includes a variable focal length lens for electrically changing the focal length and thus can adjust the focus using the autofocus function in a short time. The auto-focusing method is not limited to the above-mentioned method, and other known methods may be used instead.

The operation unit 80 obtains an operation signal in response to a user operation and sends the signal to the control unit 70. The operation unit 80 is, for example, a button, a key, a touch panel display, or a microphone.

The display unit 82 displays an image generated by the control unit 70. The display unit 82 is, for example, a display such as a liquid crystal display (LCD).

The storage unit 84 stores programs and data for the control unit 70 to perform various kinds of calculation processing and control processing. Moreover, the storage unit 84 is also used as a work area for the control unit 70. The storage unit 84 is, for example, a random access memory (RAM), a read only memory (ROM), or a hard disk.

The function of the control unit 70 can be implemented by executing a program stored in the storage unit 84 using hardware such as various processors (including a central processing unit (CPU) and a digital signal processor (DSP)). The control unit 70 executes processing for controlling the units constituting the analyzer 100. For example, the control unit 70 controls the electron optical system 10, the imaging device 60, and the WDS 50. The control unit 70 performs processing for adjusting the position of the specimen S so as to satisfy the focusing condition of the WDS 50. The processing of the control unit 70 will be specifically described later.

### 2. Method for Acquiring Spectrum

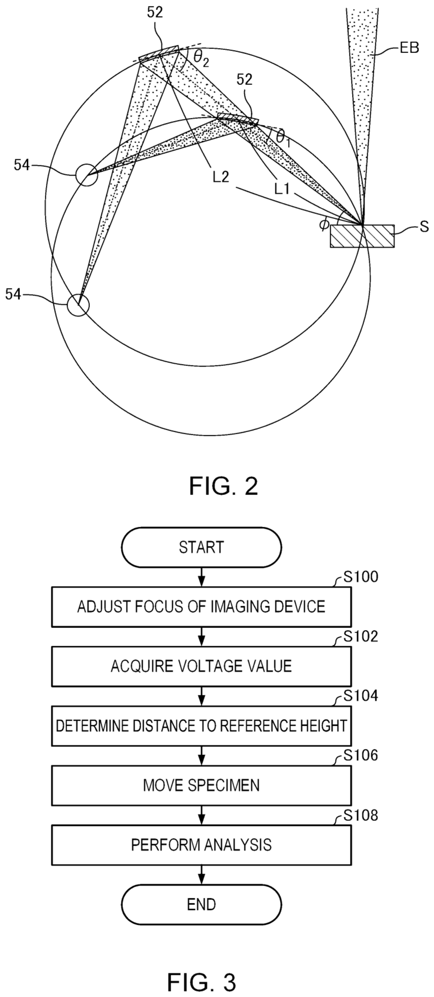

FIG. 2 is a diagram for describing a method for acquiring a spectrum in the WDS 50.

In the WDS 50, an analysis point (irradiation position of the electron beam EB) on the specimen S, the spectroscopic element 52, and the X-ray detector 54 are arranged on the Rowland circle so as to satisfy the focusing condition satisfying Bragg's law. The spectroscopic element 52 moves on a straight line inclined by an extraction angle φ from the analysis point. Furthermore, the X-ray detector 54 also moves according to the movement of the spectroscopic element 52. The distance between the analysis point and the spectroscopic element 52 is equal to the distance between the spectroscopic element 52 and the X-ray detector 54.

When the position (spectroscopic position L) of the spectroscopic element 52 is changed with respect to the fixed position of the specimen S (analysis point position), an incident angle θ of an X-ray with respect to the spectroscopic element 52 is changed. The spectroscopic position L is represented by the distance between the specimen S (analysis point) and the spectroscopic element 52.

In the example illustrated in FIG. 2, the spectroscopic element 52 is moved from a spectroscopic position L1 where the distance between the specimen S and the spectroscopic element 52 is L1 to a spectroscopic position L2 where the distance between the specimen S and the spectroscopic element 52 is L2 (L1 < L2). This changes the incident angle θ from θ₁ to θ₂ (θ₁ < θ₂).

The change of the incident angle θ according to Bragg's law varies the energy (wavelength) of X-rays detected by the X-ray detector 54. Therefore, by fixing the position of the specimen S and changing the spectroscopic position L, an X-ray spectrum can be obtained with the horizontal axis representing energy (wavelength, spectroscopic position L) and the vertical axis representing X-ray intensity.

As described above, when the specimen S is analyzed using the WDS 50, the analysis point on the specimen S needs to be located at the position satisfying the focusing condition. For this reason, the specimen S needs to be placed at the reference height located to satisfying the focusing condition. In the analyzer 100, the specimen S can be automatically placed at the reference height.

### 3. Analysis Method

### 3.1. Analysis Processing

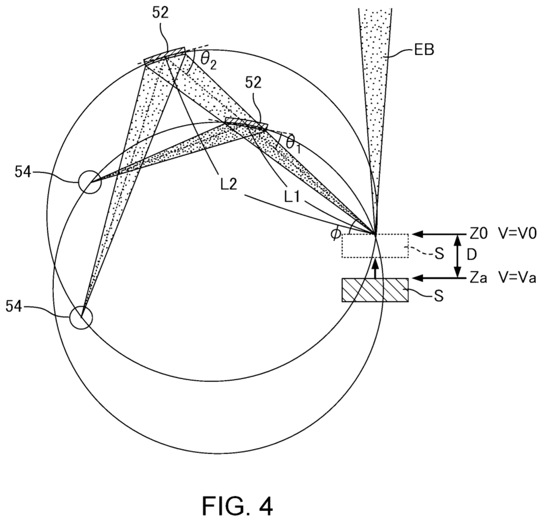

FIG. 3 is a flowchart illustrating an example of analysis processing of the control unit 70. The analysis processing includes processing for placing the specimen S at the reference height. FIG. 4 is a diagram for describing processing for placing the specimen S at a reference height Z0.

The control unit 70 first adjusts the focus of the imaging device 60 to the specimen S (step S100). The control unit 70 adjusts the focus of the imaging device 60 to the specimen S using the autofocus function of the imaging device 60. The imaging device 60 changes the focal length by varying a lens voltage V applied to the liquid lens 66. Therefore, the focus of the imaging device 60 can be adjusted in a short time. In the example illustrated in FIG. 4, the specimen S has a height Za, and the focus of the imaging device 60 is adjusted to the specimen S located at the height Za.

Next, the control unit 70 acquires information on a voltage value Va of the lens voltage V applied to the liquid lens 66 when the focus of the imaging device 60 is adjusted to the specimen S (step S102). The control unit 70 acquires the information on the voltage value Va from the imaging device 60.

On the basis of the voltage value Va acquired in the process of step S102, the control unit 70 then determines a distance D between the reference height Z0, which is the position satisfying the focusing condition, and the height Za of the specimen S when the focus of the imaging device 60 is adjusted to the specimen S (step S104).

At this point, information on the relationship between the lens voltage V applied to the liquid lens 66 and the distance D is stored in advance in the storage unit 84. The information on the relationship between the lens voltage V and the distance D may be a relational expression showing the relationship between the lens voltage V and the distance D, or may be a table showing the relationship between the lens voltage V and the distance D. The method for acquiring the information on the relationship between the lens voltage V and the distance D will be described later.

The control unit 70 determines the distance D from the voltage value Va acquired in the process of step S102, by using the information on the relationship between the lens voltage V and the distance D. By using the information on the relationship between the lens voltage V and the distance D, the distance D can be determined from the voltage value Va.

The control unit 70 moves the specimen S to the specimen stage 20 by the determined distance D (step S 106). This can place the specimen S at the reference height Z0 satisfying the focusing condition of the WDS 50. At this time, the control unit 70 sets the lens voltage V to an initial value V0. Here, the initial value V0 of the lens voltage V is a voltage value at which the focus of the imaging device 60 is adjusted to the specimen S when the specimen S is located at the reference height Z0. Therefore, by setting the lens voltage V to the initial value V0, the control unit 70 can adjust the focus of the imaging device 60 to the specimen S located at the reference height Z0.

Next, as illustrated in FIG. 2, the control unit 70 analyzes the specimen S by using the WDS 50 (step S108). For example, the control unit 70 controls the WDS 50 to analyze the specimen S, and acquires an X-ray spectrum of the specimen S. Since the specimen S is placed at the reference height Z0, the focusing condition of the WDS 50 is satisfied, achieving preferable analysis using the WDS 50. After performing the analysis, the control unit 70 terminates the analysis processing.

### 3.2. Relationship between Lens Voltage V and Distance D

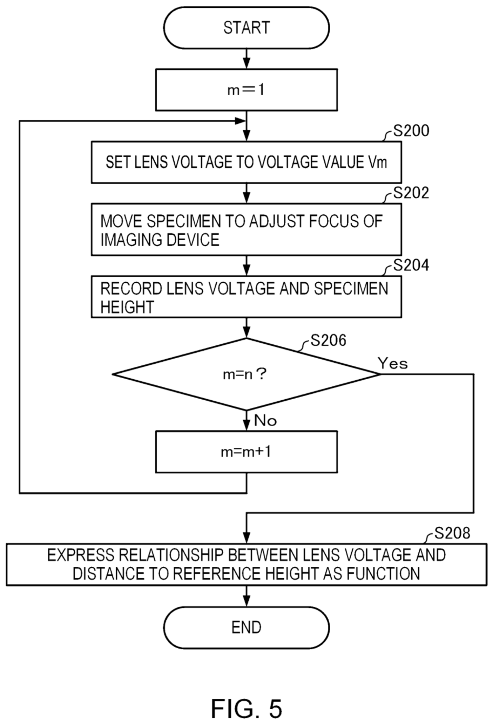

FIG. 5 is a flowchart illustrating an example of processing for obtaining information on the relationship between the lens voltage V and the distance D by the control unit 70. The information on the relationship between the lens voltage V and the distance D is used in processing for determining the distance D illustrated in FIG. 3 (step S104).

The control unit 70 first sets the lens voltage V to a voltage value Vm, and applies the voltage of the voltage value Vm to the liquid lens 66 (step S200). In this case, the control unit 70 first sets the lens voltage V to a voltage value V1 (an example of a first value) with m = 1, and applies the lens voltage V to the liquid lens 66. Since the control unit 70 sets the lens voltage V to the voltage value V1, the focal length of the imaging device 60 corresponds to the voltage value V1.

For example, the voltage value V1 is the minimum value of the range of the lens voltage V. Note that the voltage value V1 is not limited to the minimum value of the range of the lens voltage V and may be any value in the range of the lens voltage V. The voltage value V1 may be, for example, the maximum value or a median value of the range of the lens voltage V.

The control unit 70 then operates the specimen stage 20 with the lens voltage V set at the voltage value V1 to move the specimen S into the focus of the imaging device 60 (step S202). For example, the control unit 70 repeatedly captures an optical image of the specimen S by the imaging device 60 and moves the specimen S with the specimen stage 20, so that the specimen S is moved to a position where the focus value of the optical image is maximized. This can adjust the specimen S into the focus of the imaging device 60. The height of the specimen S at this time is denoted as Z1 (an example of the first position). That is, the height Z1 of the specimen S allows the focus of the imaging device 60 to be adjusted to the specimen S when the lens voltage V is set to the voltage value V1.

The control unit 70 associates the voltage value V1 and the height Z1 of the specimen S and store the value and the height in the storage unit 84 (step S204).

The control unit 70 determines whether or not the processing of step S200, step S202, and step S204 has been performed a preset number of times n, that is, whether or not m = n is satisfied (step S206). For example, the number of times n of processing is preset by a user. Information on the number of times n of processing is stored in, for example, the storage unit 84. The control unit 70 compares the number of times of processing with the number of times n of processing in the storage unit 84, and determines whether or not the processing has been performed the set number of times n.

When the control unit 70 determines that the processing has not been performed the set number of times n (No at step S206), the control unit 70 determines m=m+1(m=1) and returns to step S200 to change the lens voltage V from the lens voltage V1 to a voltage value V2 (an example of a second value) (step S200).

For example, the control unit 70 increases the lens voltage V by a predetermined amount to change the lens voltage V from the voltage value V1 to the voltage value V2.

The control unit 70 operates the specimen stage 20 with the lens voltage V set at the voltage value V2 to move the specimen S into the focus of the imaging device 60 (step S202). The control unit 70 associates the voltage value V2 with a height Z2 (an example of a second position) of the specimen S when the focus of the imaging device 60 is adjusted to the specimen S with the lens voltage V set to the voltage value V2, and stores the voltage value and the height in the storage unit 84 (step S204).

The control unit 70 then determines whether or not the processing has been performed the set number of times n (step S206). When it is determined that the processing has not been performed the set number of times n (No at step S206), the lens voltage V is changed from the voltage value V2 to a voltage value V3 (step S200).

In this manner, the control unit 70 repeats the processing of step S200, step S202, step S204, and step S206 until it is determined that the processing has been performed the set number of times n.

When it is determined that the processing has been performed the predetermined number of times n, that is, when it is determined that m=n is satisfied (YES at step S206), the control unit 70 expresses, as a function, the relationship between the lens voltage V and the distance D on the basis of information on the relationship between the lens voltage V and the height Z of the specimen S, the information being stored in the storage unit 84 (step S208).

For example, the storage unit 84 stores the voltage value V1 and the height Z1 of the specimen S, the voltage value V2 and the height Z2 of the specimen S, ... , and a voltage value Vn and a height Zn of the specimen S. For example, in the case of the height Z1, the distance D corresponds to the difference between the reference height Z0 and the height Z1. Therefore, the relational expression indicating the relationship between the lens voltage V and the distance D can be determined on the basis of information on the relationship between the lens voltage V and the height Z of the specimen S, the information being stored in the storage unit 84.

The control unit 70 stores the relational expression indicating the relationship between the lens voltage V and the distance D in the storage unit 84. The control unit 70 then terminates the processing for acquiring the information on the relationship between the lens voltage V and the distance D.

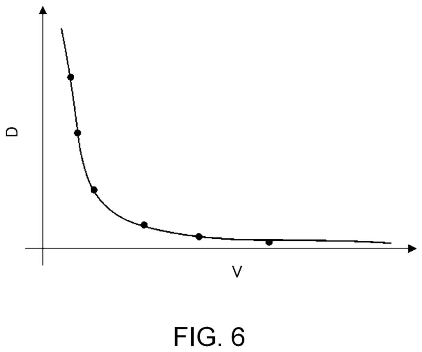

FIG. 6 is a graph illustrating the relationship between the lens voltage V and the distance D. The control unit 70 can obtain the relational expression indicating the relationship between the lens voltage V and the distance D illustrated in FIG. 6 by performing the processing illustrated in FIG. 5.

### 3.3. Simultaneous Observation of Electron Microscopic Image and Optical Image

The analyzer 100 can obtain an electron image including a secondary electron image captured using the electron optical system 10 and the secondary electron detector 30 and a backscattered electron image captured using the electron optical system 10 and the backscattered electron detector 40. In addition, in the analyzer 100, an optical image captured using the imaging device 60 can be acquired. In the analyzer 100, in order to simultaneously observe an electron image and an optical image, it is necessary to adjust both the focus of the electron optical system 10 and the focus of the imaging device 60.

In this case, the imaging device 60 is used to adjust the position of the specimen S to the reference height Z0, leading to a small focal depth. For example, the focal depth of the imaging device 60 is smaller than the focal depth of the electron optical system 10. Therefore, when the observation field of view is moved and the height of the specimen S is changed, even if an electronic image is in sharp focus, an optical image may be out of focus. In consideration of the difference between the focal depth of the imaging device 60 and the focal depth of the electron optical system 10, the analyzer 100 performs processing to allow simultaneous observation of the electron image and the optical image.

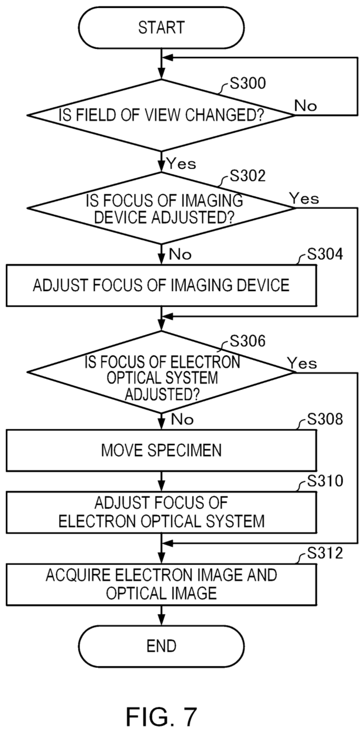

FIG. 7 is a flowchart illustrating an example of the analysis processing of the control unit 70.

The control unit 70 first determines whether or not the observation field of view has been changed (step S300). When the specimen stage 20 moves the specimen S, the control unit 70 determines that the observation field of view has been changed.

When it is determined that the observation field of view has been changed (YES in step S300), the control unit 70 determines whether or not the focus of the imaging device 60 is adjusted to the specimen S (step S302).

On the basis of the optical image of the specimen S captured by the imaging device 60, the control unit 70 determines whether or not the focus of the imaging device 60 is adjusted to the specimen S. For example, the control unit 70 causes the imaging device 60 to capture an image of the specimen S to acquire an optical image, and calculates a focus value from the acquired optical image. Thereafter, the control unit 70 determines that the focus of the imaging device 60 is not adjusted to the specimen when the focus value is smaller than a threshold value. In contrast, the control unit 70 determines that focus of the imaging device 60 is adjusted to the specimen when the focus value is equal to or greater than the threshold value. The imaging control unit 61 may determine whether or not the focus of the imaging device 60 is adjusted to the specimen.

When it is determined that the focus of the imaging device 60 is not adjusted to the specimen S (No at step S302), the control unit 70 adjusts the focus of the imaging device 60 to the specimen S (step S304). The control unit 70 adjusts the focus of the imaging device 60 to the specimen S using the autofocus function of the imaging device 60.

After the focus of the imaging device 60 is adjusted to the specimen S (after step S304), or when it is determined that the focus of the imaging device 60 is adjusted to the specimen S (YES at step S302), the control unit 70 determines whether or not the focus of the electron optical system 10 is adjusted to the specimen S (step S306).

The control unit 70 determines whether or not the focus of the electron optical system 10 is adjusted to the specimen S on the basis of the secondary electron image of the specimen S captured by the electron optical system 10 and the secondary electron detector 30. The control unit 70 determines whether or not the focus of the electron optical system 10 is adjusted to the specimen according to a method similar to the processing (step S302) of determining whether or not the focus of the imaging device 60 is adjusted to the specimen S, except for the use of an electron image.

For example, the control unit 70 causes the electron optical system 10 and the secondary electron detector 30 to capture an image of the specimen S to acquire a secondary electron image, and calculates a focus value proportional to the contrast of the secondary electron image from the acquired secondary electron image. When the focus value is smaller than the threshold value, the control unit 70 determines that the focus of the electron optical system 10 is not adjusted to the specimen. In contrast, when the focus value is equal to or greater than the threshold value, the control unit 70 determines that the focus of the electron optical system 10 is adjusted to the specimen. Note that the method for determining whether or not the focus of the electron optical system 10 is adjusted to the specimen S is not limited to the above-described method, and any other known methods may be used instead. In the above description, the secondary electron image is used to determine whether or not the focus of the electron optical system 10 is adjusted to the specimen S. A backscattered electron image may be used instead.

When it is determined that the focus of the electron optical system 10 is not adjusted to the specimen S (No at step S306), the control unit 70 causes the specimen stage 20 to move the specimen S to the reference height Z0 on the basis of the value of voltage applied to the liquid lens 66 (step S308).

The control unit 70 performs the processing for acquiring the voltage value illustrated in FIG. 3 (step S102), the processing for determining the focal length (step S104), and the processing for moving the specimen S (step S106), and moves the specimen S to the reference height Z0. At this time, the control unit 70 sets the lens voltage V to the initial value V0, and adjusts the focus of the imaging device 60 to the specimen S located at the reference height Z0.

The control unit 70 then adjusts the focus of the electron optical system 10 to the specimen S (step S310). The control unit 70 adjusts the focus of the electron optical system 10 to the specimen S using the autofocus function.

The analyzer 100 has the autofocus function of the electron optical system 10. For example, in a state in which the exciting current of the objective lens 18 is set to any value, the control unit 70 captures an image of the specimen S to acquire an electron image (secondary electron image or backscattered electron image), and calculates a focus value from the acquired electron image. The control unit 70 then changes the exciting current of the objective lens 18, captures an image of the specimen S to acquire an electron image, and calculates the focus value. As described above, the control unit 70 repeats the process of changing the exciting current of the objective lens 18, acquiring an electron image, and calculating the focus value of the electron image to search for an exciting current with the maximum focus value. The control unit 70 sets the value of the exciting current with the maximum focus value, as the exciting current of the objective lens 18. Thus, the exciting current with the maximum focus value is applied to the objective lens 18, and the focus of the objective lens 18 (electron optical system 10) can be adjusted to the specimen S.

After the focus of the electron optical system 10 is adjusted to the specimen S (after step S310), or when it is determined that the focus of the electron optical system 10 is adjusted to the specimen S (YES at step S306), the control unit 70 causes the electron optical system 10 and the secondary electron detector 30 (or backscattered electron detector 40) to capture an electron image, causes the imaging device 60 to capture an optical image, and acquires the electron image and the optical image (step S312). The control unit 70 displays the acquired electron image and optical image on the display unit 82. The control unit 70 then terminates the observation processing.

### 3.4. Lens Voltage Map

In the analyzer 100, coordinates (X,Y,Z) representing the position of the specimen S and the lens voltage V applied to the liquid lens 66 are associated with each other and are stored in the storage unit 84 when the specimen S is moved by the specimen stage 20 to change the observation field of view. Thus, the control unit 70 generates a lens voltage map (X,Y,Z,V) in which information on the lens voltage V is stored in each pixel representing the position of the specimen S.

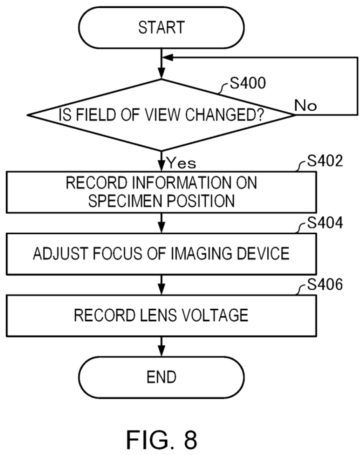

FIG. 8 is a flowchart illustrating an example of processing for generating a lens voltage map by the control unit 70.

The control unit 70 determines whether or not the observation field of view has been changed (step S400). When the specimen stage 20 moves the specimen S in the horizontal direction, the control unit 70 determines that the observation field of view has been changed.

When it is determined that the observation field of view has been changed (Yes at step S400), the control unit 70 acquires the information on the position of the specimen S (step S402). The information on the position of the specimen S corresponds to information on the position of the specimen stage 20. The control unit 70 acquires the information of the position of the specimen S from information on the coordinates of the specimen stage 20. The information on the position of the specimen S includes information on the position (X,Y) of the specimen S in the horizontal direction and information on the position (Z) of the specimen S in the vertical direction (height direction). That is, the information on the position of the specimen S is represented by the coordinates (X,Y,Z) of the X-axis, Y-axis, and Z-axis that are orthogonal to one another.

The control unit 70 then adjusts the focus of the imaging device 60 to the specimen S (step S404). The control unit 70 adjusts the focus of the imaging device 60 to the specimen S using the autofocus function of the imaging device 60.

The control unit 70 then acquires information on the voltage value Va of the lens voltage V applied to the liquid lens 66 when the focus of the imaging device 60 is adjusted to the specimen S (step S406). The control unit 70 associates the information on the voltage value Va with the information (X,Y,Z) on the position of the specimen S and stores the information in the storage unit 84. Thus, in the storage unit 84, the lens voltage map (X,Y,Z,V) is generated, in which the information on the lens voltage V is stored in each pixel representing the position of the specimen S. The control unit 70 then terminates the processing for generating the lens voltage map.

By using the lens voltage map, information on the voltage value V (X,Y,Z,V) at each position of the specimen S can be recognized before the position of the specimen S is changed. Therefore, the focus of the imaging device 60 can be adjusted to the specimen S before the position of the specimen S is changed. In addition, the distance D between the position of the specimen S and the reference height Z0 can be calculated from the voltage value Va. Therefore, by using the lens voltage map, the distance D for adjustment to the reference height Z0 can be calculated before the position of the specimen S is changed.

### 4. Effects

The analyzer 100 includes: the specimen stage 20 that supports the specimen S and is capable of changing the position of the specimen S, an electron optical system 10 that irradiates the specimen S with the electron beam EB, the WDS 50 that separates and detects X-rays with a specific wavelength from X-rays emitted from the specimen S, and the imaging device 60 for capturing an optical image of the specimen S, and the control unit 70 that adjusts the position of the specimen S so as to satisfy the focusing condition of the WDS 50, the imaging device 60 including the liquid lens 66 that electrically changes the focal length. Furthermore, on the basis of the value of an electric signal supplied to the liquid lens 66 when the focus of the imaging device 60 is adjusted to the specimen S, the control unit 70 causes the specimen stage 20 to move the specimen S to a position satisfying the focusing condition. Therefore, in the analyzer 100, the specimen S can be placed in a short time at the reference height Z0 satisfying the focusing condition of the WDS 50.

For example, in a conventional analyzer, it is necessary to move the specimen stage to adjust the focus of the imaging device to the specimen. In contrast, the analyzer 100 includes the liquid lens 66 that electrically changes the focal length, thereby adjusting the focus of the imaging device 60 to the specimen S without moving the specimen stage 20. Therefore, in the analyzer 100, the specimen S can be placed at the reference height Z0 in a short time.

In the analyzer 100, the control unit 70 determines, on the basis of the value of the electric signal applied to the liquid lens 66, the distance D between the position satisfying the focusing condition of the WDS 50 and the position of the specimen S when the focus of the imaging device 60 is adjusted to the specimen S, and then the control unit 70 moves the specimen stage 20 by the distance D. Therefore, in the analyzer 100, the specimen S can be disposed at the reference height Z0 in a short time.

The analyzer 100 includes the storage unit 84 that stores information on the relationship between the value of the electric signal (lens voltage V) and the distance D, and the control unit 70 uses the information to determine the distance D from the value of the electric signal. Thus, the analyzer 100 can determine the distance D from the value of the electric signal. This allows the analyzer 100 to easily determine the distance D from the voltage value of the lens voltage V applied to the liquid lens 66, that is, the amount of movement of the specimen S to the reference height Z0.

In the analyzer 100, the control unit 70 performs processing for setting the value of the electric signal to the first value and supplying the electric signal to the liquid lens 66; processing for causing the specimen stage 20 to move the specimen S to adjust the focus of the imaging device 60 to the specimen S in a state in which the value of the electric signal is set to the first value; processing for storing, in the storage unit 84, the first value and the first position of the specimen S when the focus of the imaging device 60 is adjusted to the specimen S, the first value and the first position being associated with each other; processing for setting the value of the electric signal to the second value different from the first value and supplying the electric signal to the liquid lens 66; processing for causing the specimen stage 20 to move the specimen S to adjust the focus of the imaging device 60 to the specimen S in a state in which the value of the electric signal is set to the second value; processing for storing, in the storage unit 84, the second value and the second position of the specimen S when the focus of the imaging device 60 is adjusted to the specimen S, the second value and the second position being associated with each other; and processing for determining information on the relationship between the value of the electric signal (lens voltage V) and the distance D on the basis of the value of the electric signal including the first value and the second value and the position of the specimen S including the first position and the second position. Thus, in the analyzer 100, the information on the relationship between the value of the electric signal (lens voltage V) and the distance D can be acquired.

The analyzer 100 includes the detector (secondary electron detector 30 or backscattered electron detector 40) that detects electrons emitted from the specimen S by irradiating the specimen S with the electron beam EB. Furthermore, the control unit 70 performs processing for determining whether or not the observation field of view has been changed, processing for determining whether or not the focus of the imaging device 60 is adjusted to the specimen S when it is determined that the observation field of view has been changed; processing for operating the imaging device 60 to adjust the focus of the imaging device 60 to the specimen S when it is determined that the focus of the imaging device 60 is not adjusted to the specimen S; processing for determining whether or not the focus of the electron optical system 10 is adjusted to the specimen S; and processing for causing the specimen stage 20 to move the specimen S to a position satisfying the focusing condition on the basis of the value of the electric signal and operating the electron optical system 10 to adjust the focus of the electron optical system 10 to the specimen S when it is determined that the focus of the electron optical system 10 is not adjusted to the specimen S. Therefore, in the analyzer 100, when the observation field of view is changed, the focus of the imaging device 60 and the focus of the electron optical system 10 can be adjusted to the specimen S. This can easily acquire both of an optical image of the specimen S and an electron image of the specimen S in the analyzer 100.

An analysis method using the analyzer 100 includes the steps of: adjusting the focus of the imaging device 60 to the specimen S using the liquid lens 66; obtaining the value of the electric signal supplied to the liquid lens 66 when the focus of the imaging device 60 is adjusted to the specimen S; and moving the specimen S to a position satisfying the focusing condition on the basis of the value of the electric signal. Therefore, in the analysis method using the analyzer 100, the specimen S can be placed at the reference height Z0 in a short time.

In the analysis method using the analyzer 100, the step of moving the specimen S includes determining, on the basis of the value of the electric signal, the distance D between the position satisfying the focusing condition of the WDS 50 and the position of the specimen S when the focus of the imaging device 60 is adjusted to the specimen S, and moving the specimen stage 20 by the distance D. Therefore, in the analysis method using the analyzer 100, the specimen S can be placed at the reference height Z0 in a short time.

The analysis method using the analyzer 100 includes acquiring information on the relationship between the value of the electric signal (lens voltage V) and the distance D, and the step of moving the specimen S includes determining the distance D from the value of the electric signal by using the information on the relationship between the value of the electric signal (lens voltage V) and the distance D. Therefore, in the analysis method using the analyzer 100, the distance D can be determined from the value of the electric signal. Thus, the analysis method using the analyzer 100 can easily determine the distance D, that is, the amount of movement of the specimen S to the reference height Z0, from the voltage value of the lens voltage V applied to the liquid lens 66.

The analysis method using the analyzer 100 includes the step of acquiring information on the relationship between the value of the electric signal (lens voltage V) and the distance D, wherein the step of acquiring the information includes the steps of: setting the value of the electric signal to the first value and supplying the electric signal to the liquid lens 66; moving the specimen S to adjust the focus of the imaging device 60 to the specimen S in a state in which the value of the electric signal is set to the first value; storing the first value and the position of the specimen S when the focus of the imaging device 60 is adjusted to the specimen S, the first value and the position being associated with each other; setting the value of the electric signal to the second value different from the first value and supplying the electric signal to the liquid lens 66; moving the specimen S to adjust the focus of the imaging device 60 to the specimen S in a state in which the value of the electric signal is set to the second value; storing the second value and the position of the specimen S when the focus of the imaging device 60 is adjusted to the specimen S, the second value and the position being associated with each other; and determining information on the relationship between the value of the electric signal (lens voltage V) and the distance D on the basis of the value of the electric signal including the first value and the second value and the position of the specimen S including the first position and the second position. Thus, the analysis method using the analyzer 100 can acquire the information on the relationship between the value of the electric signal (lens voltage V) and the distance D.

The analysis method using the analyzer 100 includes the steps of: determining whether or not the observation field of view has been changed; capturing an image of the specimen S using the imaging device 60 and acquiring an optical image of the specimen S when it is determined that the observation field of view has been changed; determining whether or not the focus of the imaging device 60 is adjusted to the specimen S on the basis of the optical image; operating the imaging device 60 to adjust the focus of the imaging device 60 to the specimen S when it is determined that the focus of the imaging device 60 is not adjusted to the specimen S; capturing an electron image using the electron optical system 10 and the secondary electron detector 30; determining whether or not the focus of the electron optical system 10 is adjusted to the specimen S on the basis of the electron image; and moving the specimen S to a position satisfying the focusing condition on the basis of the value of the electric signal and operating the electron optical system 10 to adjust the focus of the electron optical system 10 to the specimen S when it is determined that the focus of the electron optical system 10 is not adjusted to the specimen S. Therefore, both of the optical image of the specimen S and the electron image of the specimen S can be easily obtained in the analysis method using the analyzer 100.

### 5. Modification Examples

Note that the present invention is not limited to the above-described embodiments, and various modifications can be made within the scope of the present invention.

### 5.1. First Modification Example

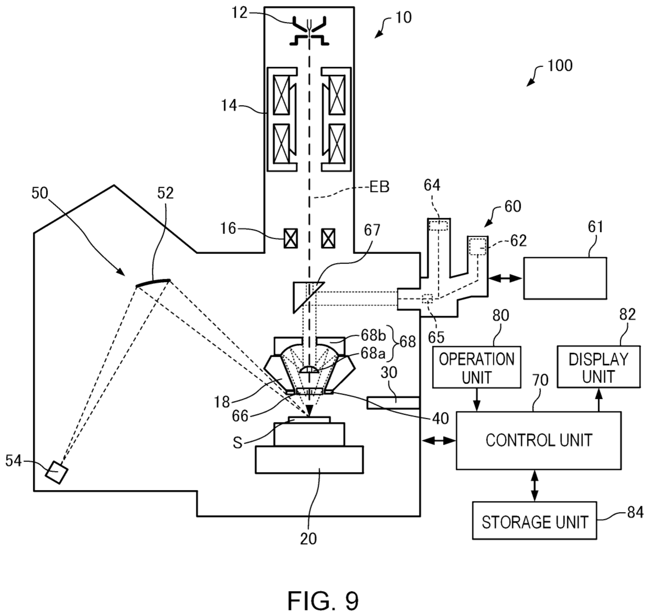

FIG. 9 illustrates an example of the configuration of the analyzer 100 according to the first modification example.

In the analyzer 100 illustrated in FIG. 1, the liquid lens 66 is disposed on the optical path between the imaging element 62 and the objective lens 68. In contrast, as illustrated in FIG. 9, the liquid lens 66 may be disposed on an optical path between the objective lens 68 and the specimen S. In other words, the objective lens 68 may be disposed on the optical path between the imaging element 62 and the liquid lens 66. In this case, since the liquid lens 66 is disposed on the optical path of the electron beam EB, the liquid lens 66 may have, for example, a through hole for passing the electron beam EB. The liquid lens 66 disposed between the objective lens 68 and the specimen S can extend a range in which the focal length can be adjusted, as compared with the case where the liquid lens 66 is disposed between the imaging element 62 and the objective lens 68.

Thus, the liquid lens 66 disposed between the objective lens 68 and the specimen S can adjust the focal length before the image of the specimen S is enlarged by the objective lens 68. The focal length is adjusted by the liquid lens 66 before the image of the specimen S is enlarged by the objective lens 68, thereby extending the range in which the focal length can be adjusted, as compared with the case where the focal length is adjusted by the liquid lens 66 after the image of the specimen S is enlarged by the objective lens 68.

### 5.2. Second Modification Example

In the embodiment illustrated in FIG. 1, the WDS 50 is used as a spectrometer for separating and detecting X-rays with a specific wavelength from X-rays emitted from the specimen S. The spectrometer for separating and detecting X-rays with a specific wavelength from X-rays emitted from the specimen S is not limited to the WDS. For example, a soft X-ray emission spectrometer (SXES) may be used as a spectrometer for separating and detecting X-rays with a specific wavelength from X-rays emitted from the specimen S.

In the WDS 50, the energy of X-rays is analyzed using the spectroscopic element 52, and the spectroscopic X-rays are detected by the X-ray detector 54, whereas in the SXES, the energy of X-rays is analyzed using a diffraction grating, and the spectrum is detected using a CCD detector. Also in the case where the analyzer 100 includes the SXES, the same operations and effects can be obtained as those of the analyzer 100 including the WDS 50.

Note that the embodiments and the modification examples described above are merely exemplary, and the present invention is not limited thereto. For example, the embodiments and modification examples can be combined as appropriate.

The invention is not limited to the above-described embodiments, and various modifications can be made. For example, the invention includes configurations that are substantially the same as the configurations described in the embodiments. Substantially same configurations mean configurations having the same functions and methods, for example. The invention also includes configurations obtained by replacing non-essential elements of the configurations described in the embodiments with other elements. The invention further includes configurations obtained by adding known art to the configurations described in the embodiments.

## Claims

1. An analyzer comprising:
a specimen stage that supports a specimen and is capable of changing a position of the specimen;
an electron optical system that irradiates the specimen with an electron beam;
a spectrometer that separates and detects an X-ray with a specific wavelength from X-rays emitted from the specimen;
an imaging device that captures an optical image of the specimen; and
a control unit that adjusts a position of the specimen so as to satisfy a focusing condition of the spectrometer,
wherein
the imaging device includes a variable focal length lens that electrically changes a focal length, and
the control unit causes the specimen stage to move the specimen to a position satisfying the focusing condition based on a value of an electric signal supplied to the variable focal length lens when a focus of the imaging device has been adjusted to the specimen.

2. The analyzer according to claim 1, wherein
the control unit determines, based on a value of the electric signal, a distance between the position satisfying the focusing condition and a position of the specimen obtained when the focus of the imaging device has been adjusted to the specimen, and then the control unit moves the specimen stage by the distance.

3. The analyzer according to claim 2, further comprising
a storage unit that stores information on a relationship between a value of the electric signal and the distance,
wherein the control unit uses the information to determine the distance from a value of the electric signal.

4. The analyzer according to claim 3, wherein
the control unit performs:
processing for setting a value of the electric signal to a first value, and supplying the electric signal to the variable focal length lens;
processing for causing the specimen stage to move the specimen to adjust the focus of the imaging device to the specimen, in a state in which a value of the electric signal is set to the first value;
processing for associating the first value with a first position of the specimen obtained when the focus of the imaging device has been adjusted to the specimen, and storing the associated first value and first position in the storage unit;
processing for setting a value of the electric signal to a second value different from the first value, and supplying the electric signal to the variable focal length lens;
processing for causing the specimen stage to move the specimen to adjust the focus of the imaging device to the specimen, in a state in which a value of the electric signal is set to the second value;
processing for associating the second value with a second position of the specimen obtained when the focus of the imaging device has been adjusted to the specimen, and storing the associated second value and second position in the storage unit; and
processing for determining the information based on values of the electric signal including the first value and the second value and positions of the specimen including the first position and the second position.

5. The analyzer according to any one of claims 1 to 4, further comprising
a detector that detects an electron emitted from the specimen irradiated with an electron beam,
wherein the control unit performs:
processing for determining whether or not an observation field of view has been changed;
processing for determining whether or not the focus of the imaging device is adjusted to the specimen when the observation field of view has been determined to have been changed;
processing for operating the imaging device to adjust the focus of the imaging device to the specimen when the focus of the imaging device has been determined not to be adjusted to the specimen;
processing for determining whether or not a focus of the electron optical system is adjusted to the specimen; and
processing for causing, when the focus of the electron optical system has been determined not to be adjusted to the specimen, the specimen stage to move the specimen to a position satisfying the focusing condition, based on a value of the electric signal, and operating the electron optical system to adjust the focus of the electron optical system to the specimen.

6. The analyzer according to any one of claims 1 to 5, wherein
the imaging device includes:
an imaging element; and
an objective lens disposed on an optical path between the imaging element and the variable focal length lens.

7. The analyzer according to any one of claims 1 to 6, wherein
the variable focal length lens is a liquid lens.

8. An analysis method using an analyzer including an electron optical system that irradiates a specimen with an electron beam, a spectrometer that separates and detects an X-ray with a specific wavelength from X-rays emitted from the specimen, and an imaging device that captures an optical image of the specimen and has a variable focal length lens that electrically changes a focal length, the analysis method comprising:
using the variable focal length lens to adjust a focus of the imaging device to the specimen;
acquiring a value of an electric signal supplied to the variable focal length lens when the focus of the imaging device has been adjusted to the specimen; and
moving, based on a value of the electric signal, the specimen to a position satisfying a focusing condition.

9. The analysis method according to claim 8, wherein
the step of moving the specimen includes
determining, based on a value of the electric signal, a distance between the position satisfying the focusing condition and a position of the specimen obtained when the focus of the imaging device has been adjusted to the specimen, and then moving the specimen by the distance.

10. The analysis method according to claim 9, further comprising
acquiring information on a relationship between a value of the electric signal and the distance,
wherein the step of moving the specimen includes
using the information to determine the distance based on a value of the electric signal.

11. The analysis method according to claim 10, wherein
the step of acquiring the information includes:
setting a value of the electric signal to a first value, and supplying the electric signal to the variable focal length lens;
moving the specimen to adjust the focus of the imaging device to the specimen, in a state in which a value of the electric signal is set to the first value;
associating the first value with a first position of the specimen obtained when the focus of the imaging device has been adjusted to the specimen, and storing the associated first value and first position;
setting a value of the electric signal to a second value different from the first value, and supplying the electric signal to the variable focal length lens;
moving the specimen to adjust the focus of the imaging device to the specimen, in a state in which a value of the electric signal is set to the second value;
associating the second value with a second position of the specimen obtained when the focus of the imaging device has been adjusted to the specimen, and storing the associated second value and second position; and
determining the information based on values of the electric signal including the first value and the second value and positions of the specimen including the first position and the second position.

12. The analysis method according to any one of claims 8 to 11, further comprising:
determining whether or not an observation field of view has been changed;
capturing an optical image of the specimen by using the imaging device when the observation field of view has been determined to have been changed;
determining, based on the captured optical image, whether or not the focus of the imaging device is adjusted to the specimen;
operating the imaging device to adjust the focus of the imaging device to the specimen when the focus of the imaging device has been determined not to be adjusted to the specimen;
capturing an electron microscopic image by using the electron optical system and a detector;
determining, based on the captured electron microscopic image, whether or not a focus of the electron optical system is adjusted to the specimen; and
moving, when the focus of the electron optical system has been determined not to be adjusted to the specimen, the specimen to a position satisfying the focusing condition, based on a value of the electric signal, and operating the electron optical system to adjust the focus of the electron optical system to the specimen.

13. The analysis method according to any one of claims 8 to 12, wherein
the variable focal length lens is a liquid lens.
